# DEMANDE DE BREVET EUROPEEN

(11) **EP 0 997 976 A1**
(43) Date de publication de la demande: **03.05.2000**
(21) Numéro de dépôt: 98460047.8
(22) Date de dépôt: 27.10.1998
(51) Int. Cl.: H01Q 17/00, G01R 29/08, G01R 29/10, H04B 17/00

(54) **Atténuateur de liaison radio pour terminal d'adaptation à antenne intégrée**

(71) Demandeur: TRT Lucent Technologies (SA), 92359 Le Plessis Robinson (FR)
(72) Inventeur: Perez, Manuel, 92350 Le Plessis Robinson (FR); Renier, Eric, 91800 Brunoy (FR)
(74) Mandataire: Ballot, Paul

(57) **Abrégé**

La présente invention concerne un atténuateur de liaison radio pour terminal d'adaptation à antenne intégrée. Selon l'invention, l'atténuateur se présente sous la forme d'un panneau (P) de matière absorbante disposé de manière amovible à l'extérieur du boîtier du terminal d'adaptation entre l'antenne et la station de base (SB).

Application dans le domaine des réseaux de communication sans fil fonctionnant avec la norme DECT par exemple.

## Description

La présente invention concerne un atténuateur de liaison radio pour terminal d'adaptation à antenne intégrée. La présente invention trouve tout particulièrement son application dans le domaine des réseaux de communication sans fil fonctionnant avec la norme DECT.

Un réseau sans fil comporte généralement une pluralité de terminaux d'adaptation, appelés communément en langage technique CTA (Cordless Adapter Terminal), prévus pour communiquer, d'une part, par liaison hertzienne avec une station de base en relation avec le réseau téléphonique classique et d'autre part, avec des terminaux d'abonnés (téléphones numériques ou analogiques, modems, interface NUMERIS, combinés DECT,...) par liaison hertzienne ou filaire.

Au moment de la mise en service d'une liaison radio entre un terminal d'adaptation et sa station de base, l'installateur doit non seulement vérifier le bon fonctionnement de la liaison mais également garantir au client une marge de fonctionnement de quelques décibels pour faire face à d'éventuelles mauvaises conditions atmosphériques. Cette marge de fonctionnement est typiquement de 8 décibels. Pour contrôler cette marge, l'installateur introduit généralement au moment de la vérification de la liaison un atténuateur entre l'antenne et l'émetteur/récepteur du terminal d'adaptation. Cette manipulation est simple lorsque l'antenne du terminal d'adaptation est déportée à l'extérieur de celui-ci.

Cependant, lorsque l'antenne est intégrée au terminal d'adaptation c'est-à-dire lorsqu'elle est placée à l'intérieur du boîtier du terminal d'adaptation ou lorsqu'elle tait partie intégrante de ce boîtier, il peut se révéler impossible d'opérer une telle manipulation par manque de place. Les terminaux d'adaptation sont en effet de plus en plus compacts. De plus, l'opération de montage et démontage du terminal d'adaptation pour introduire l'atténuateur à l'intérieur du boîtier du terminal peut se révéler très délicate, les terminaux d'adaptation étant généralement disposés aux sommets de pylônes.

Aussi, l'invention a pour but de proposer un atténuateur de conception simple permettant de vérifier la marge de fonctionnement d'une liaison utilisant des terminaux d'adaptation avec antenne intégrée.

Selon l'invention, on prévoit l'utilisation d'un atténuateur se plaçant à l'extérieur du boîtier du terminal d'adaptation entre l'antenne de celui-ci et la station de base associée.

Aussi, l'invention a pour objet un dispositif d'atténuation destiné à être utilisé lors de la mise en service d'une liaison radio entre une station de base et un terminal d'adaptation à antenne intégrée pour vérifier la marge de fonctionnement de ladite liaison,
caractérisé en ce qu'il se présente sous la forme d'un panneau de matière absorbante à disposer de manière amovible à l'extérieur du boîtier du terminal d'adaptation entre l'antenne et la station de base.

Ledit panneau de matière absorbante est composé d'epoxy chargé de carbone ou de billes de fer.

Pour accrocher ledit atténuateur au boîtier du terminal d'adaptation, le panneau de matière absorbante est logé de préférence dans un cadre muni de moyens d' accrochage.

D'autres caractéristiques et avantages de l'invention apparaîtront à la lecture de la description détaillée qui suit et qui est faite en référence aux dessins annexés, parmi lesquels :
- la figure 1 représente schématiquement une liaison radio entre une station de base et un terminal d'adaptation muni du dispositif d'atténuation selon l'invention,
- la figure 2 représente une première forme de réalisation du dispositif d'atténuation selon l'invention, et
- la figure 3 représente une seconde forme de réalisation du dispositif d'atténuation selon l'invention.

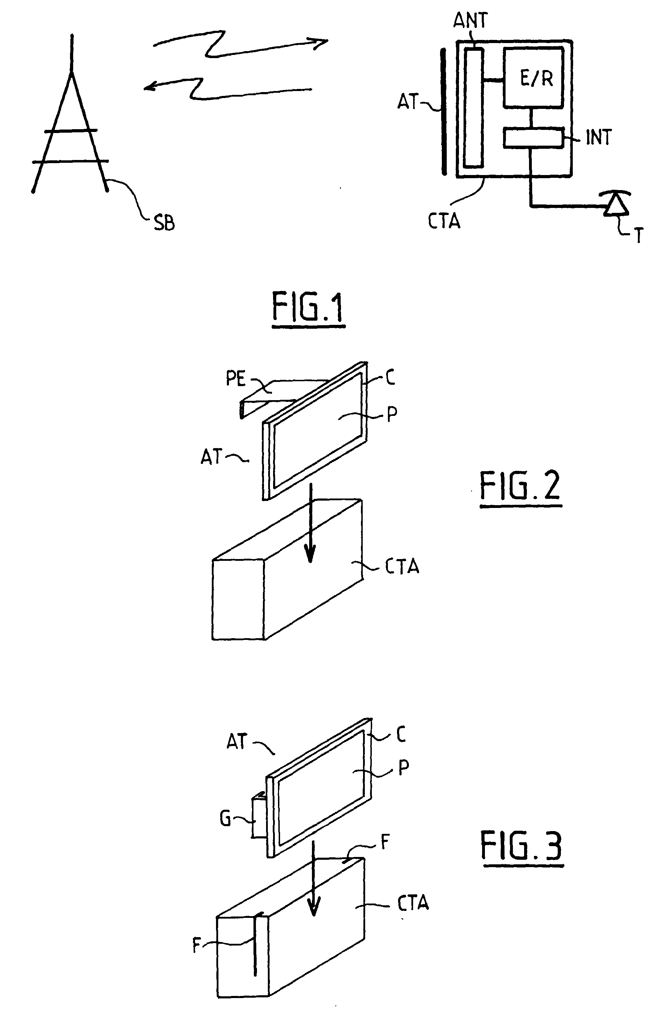

La figure 1 représente une liaison radio entre une station de base SB et un terminal d'adaptation CTA. Le terminal d'adaptation est principalement composé d'une antenne ANT, d'un émetteur/récepteur E/R et d'une interface abonné INT, l'ensemble étant regroupé dans un boîtier. Dans le cas présent, l'antenne est placée à l'intérieur du boîtier. Le dispositif de l'invention est également particulièrement avantageux lorsque l'antenne fait partie intégrante du boîtier. Par ailleurs, l'interface abonné INT est connectée à un ou plusieurs terminaux d'abonné. Dans l'exemple de la figure 1, l'interface abonné est reliée à un poste téléphonique T.

Au moment de la mise en service de cette liaison, le terminal d'adaptation CTA est muni d'un dispositif d'atténuation AT chargé d'atténuer les signaux en provenance ou à destination de la station de base SB et cela, afin de garantir une marge de fonctionnement de la liaison radio. Selon l'invention, ce dispositif d'atténuation est placé à l'extérieur du terminal d'adaptation CTA entre son antenne et la station de base SB.

Ce dispositif d'atténuation est constitué principalement d'un panneau P de matière absorbante en poudre d'epoxy chargé de carbone ou de billes de fer. Le panneau P est de préférence recouvert d'une matière plastique isolante pour le protéger des intempéries.

En référence à la figure 2, le dispositif d'atténuation de l'invention comporte avantageusement un cadre C servant de support au panneau de matière absorbante et muni de moyens d'accrochage pour accrocher le dispositif d'atténuation AT au boîtier du terminal d'adaptation CTA.

Dans l'exemple de la figure 2, les moyens d'accrochage sont composés d'une patte d'encliquetage PE destiné à être placée sur la face supérieure du boîtier du terminal CTA, dont une première extrémité est fixée au cadre C et dont une seconde extrémité présente un pan recourbé venant se plaquer contre la face arrière du boîtier lorsque l'atténuateur est en position.

Une autre forme de réalisation des moyens d'accrochage est illustrée à la figure 3. Ils se présentent sous la forme de moyens formant glissières G sur les cotés du cadre C de l'atténuateur. Des moyens complémentaires F (fentes ménagées dans les faces latérales du boîtier du terminal) sont prévus sur le terminal d'adaptation CTA.

Selon l'invention, le dispositif d'atténuation peut comporter en outre un moyen d'emmanchement (non représenté sur les figures) pour mettre en place ledit dispositif sur le boîtier du CTA au moyen d'une perche lorsque ledit boîtier est positionné au sommet d'un pylône.

## Revendications

1. Dispositif d'atténuation (ATT) destiné à être utilisé lors de la mise en service d'une liaison radio entre une station de base (SB) et un terminal d'adaptation (CTA) à antenne intégrée (ANT) pour vérifier la marge de fonctionnement de ladite liaison,
caractérisé en ce qu'il se présente sous la forme d'un panneau (P) de matière absorbante à disposer de manière amovible à l'extérieur du boîtier du terminal d'adaptation (CTA) entre l'antenne (ANT) et la station de base (SB).

2. Dispositif d'atténuation (ATT) selon la revendication 1, caractérisé en ce que le panneau (P) de matière absorbante est logé dans un cadre (C) muni de moyens d'accrochage (PE, F, G) pour accrocher ledit dispositif d'atténuation au boîtier.

3. Dispositif d'atténuation selon la revendication 1 ou 2, caractérisé en ce que ledit panneau (P) de matière absorbante est recouvert d'une matière plastique isolante pour le protéger des intempéries.

4. Dispositif d'atténuation selon l'une des revendications précédentes, caractérisé en ce que ledit panneau (P) de matière absorbante est composé d'epoxy et de carbone.

5. Dispositif d'atténuation selon l'une des revendications précédentes, caractérisé en ce que ledit panneau (P) de matière absorbante est composé d'epoxy et de fer.
